# DEMANDE DE BREVET EUROPEEN

(11) **EP 1 267 427 A1**
(43) Date de publication de la demande: **18.12.2002**
(21) Numéro de dépôt: 01202262.0
(22) Date de dépôt: 12.06.2001
(51) Int. Cl.: H01L 43/12

(54) **Procédé de fabrication en grand nombre d'une multiplicité de capteurs magnétiques**

(71) Demandeur: ASULAB S.A., 2074 Marin (CH)
(72) Inventeur: Piguet, Dominique, 1012 Lausanne (CH); Franck, Vincent, 1143 Apples (CH)
(74) Mandataire: Laurent, Jean

(57) **Abrégé**

La présente invention concerne un procédé pour fabriquer en grand nombre une multiplicité de capteurs magnétiques (1) réalisés sur un substrat semi-conducteur (4), ces capteurs (1) comprenant au moins un noyau magnétique (8) réalisé en un matériau magnétique amorphe, caractérisé en ce que, après intégration des circuits électroniques associés aux capteurs magnétiques, un film (22) de matériau magnétique amorphe est collé sur le substrat semi-conducteur (4), ce film étant ensuite structuré pour former les noyaux magnétiques (8) desdits capteurs magnétiques (1).

## Description

La présente invention concerne un procédé pour fabriquer en grand nombre une multiplicité de capteurs magnétiques. Elle s'applique en particulier, mais non exclusivement, à des capteurs magnétiques du type décrit dans la demande de brevet EP 1 052 519 au nom de la demanderesse.

Un capteur magnétique du genre susmentionné est représenté en perspective et en éclaté sur la figure 1 annexée à la présente demande de brevet. Désigné dans son ensemble par la référence numérique générale 1, ce capteur magnétique est rapporté à la surface 2 d'un substrat semi-conducteur 4 de forme sensiblement parallélépipédique. Un circuit électronique (non représenté) associé au capteur magnétique est réalisé par intégration CMOS sur la grande surface supérieure 2 du substrat semi-conducteur 4.

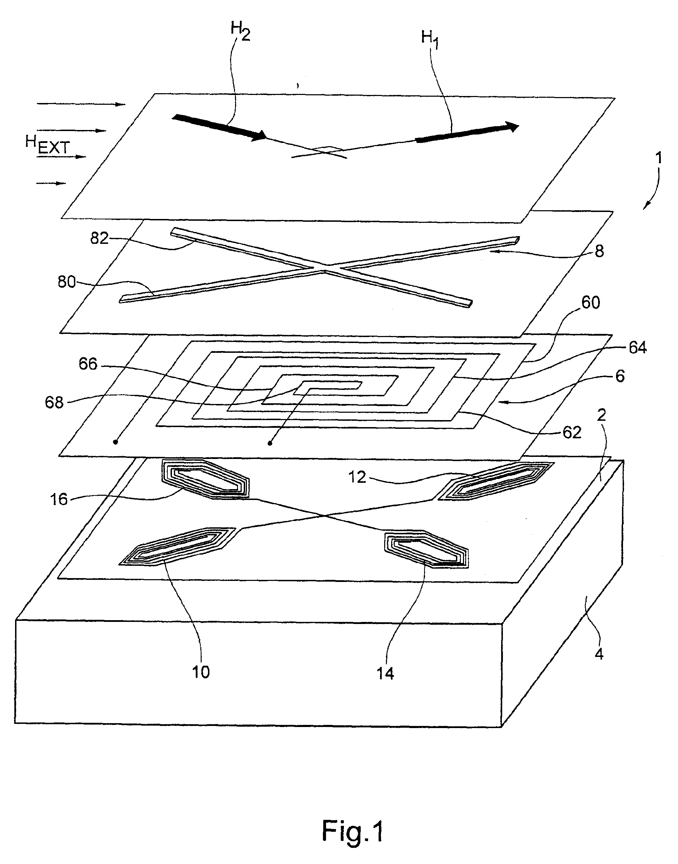

Le capteur magnétique 1 comporte une bobine d'excitation plate 6 qui est formée dans une couche métallique rapportée sur la face 2 du substrat 4 au cours du procédé d'intégration CMOS. La bobine 6 présente un périmètre extérieur constitué par sa spire externe 60 de forme substantiellement carrée. Les autres spires 62 à 68 de cette bobine d'excitation 6 sont disposées de manière concentrique par rapport à la spire externe 60. Egalement de forme carrée, les spires 62 à 68 sont de dimensions progressivement décroissantes comme cela est visible sur la figure 1.

Un noyau ferromagnétique 8 est rapporté, typiquement par collage, au-dessus de la bobine d'excitation 6. Ce noyau ferromagnétique 8 est réalisé à partir d'un ruban de matériau magnétique amorphe couramment disponible dans le commerce.

Comme on peut le voir sur la figure 1, le noyau magnétique 8 a une forme de croix qui coïncide avec les deux diagonales du carré défini par la spire externe 60 de la bobine d'excitation 6. On peut ainsi mesurer deux composantes perpendiculaires H₁ et H₂ du champ magnétique externe H_{EXT}, ces deux composantes étant respectivement dirigées selon les deux branches orthogonales 80 et 82 du noyau 8. La composante H₁ du champ magnétique externe H_{EXT} est ainsi mesurée par la branche 80 du noyau 8, tandis que la composante H₂ est mesurée par sa branche perpendiculaire 82.

La détection du champ magnétique externe H_{EXT} est réalisée au moyen de deux paires de bobines de détection coplanaires 10, 12 et 14, 16. Les deux premières bobines 10 et 12, rapportées par technologie CMOS sur la surface supérieure 2 du substrat semi-conducteur 4, sont montées en série selon un arrangement différentiel. Disposées sous la bobine plate d'excitation 6 ou dans le même plan que cette dernière, ces deux bobines 10 et 12 sont positionnées chacune en regard de l'une des extrémités libres de la branche 80 du noyau ferromagnétique 8. Cette première paire de bobines 10, 12 a donc pour rôle de détecter la composante H₁ du champ magnétique extérieur H_{EXT}.

Les deux autres bobines détectrices 14 et 16 sont identiques aux deux bobines 10 et 12 précédemment décrites. Egalement montées en série selon un arrangement différentiel, ces deux bobines détectrices 14, 16 sont disposées chacune en regard de l'une des extrémités libres de la seconde branche 82 du noyau ferromagnétique 8. Cette seconde paire de bobines 14, 16 a donc pour rôle de détecter la composante H₂ du champ magnétique extérieur H_{EXT}.

Les capteurs magnétiques du genre susdécrit sont notamment destinés à équiper des magnétomètres pour la détection, dans un plan parallèle au plan des bobines de détection, de champs magnétiques de faible à très faible valeur, par exemple pour des applications médicales. Ces magnétomètres sont alors préférentiellement réalisés selon les techniques d'intégration CMOS, leurs circuits électroniques associés étant intégrés dans le substrat sur lequel sont réalisés les capteurs.

La fabrication de tels dispositifs de détection et de mesure de champs magnétiques pose un important problème qui, à la connaissance de la demanderesse, n'a pas, à ce jour, été résolu de façon satisfaisante. En effet, les circuits électroniques associés aux capteurs magnétiques sont réalisés en technologie CMOS qui consiste en un ensemble d'étapes de conception et de fabrication des composants électroniques qui, aujourd'hui, sont remarquablement bien maîtrisées et permettent de réaliser en grand nombre des dispositifs fiables et peu coûteux.

En revanche, il n'en va pas de même avec la réalisation des capteurs magnétiques associés aux circuits électroniques mentionnés ci-dessus. Comme on l'a décrit plus haut, ces capteurs magnétiques comprennent notamment un noyau ferromagnétique amorphe. Or, aucune des techniques disponibles actuellement pour la fabrication de dispositifs à semi-conducteurs ne permet de réaliser des composants à structure amorphe. Parmi ces techniques, on peut notamment citer le dépôt en phase vapeur, mieux connu sous sa dénomination anglo-saxonne "chemical vapor deposition" (CVD), qui consiste à évaporer sous vide un métal que l'on sublime par chauffage pour former, par exemple, une couche d'oxyde ou de nitrure avec réaction chimique produite par un gaz approprié. Une autre technique, connue sous le nom d'électrodéposition ou galvanoplastie, consiste à former une couche métallique sur une pièce par électrolyse et s'applique à des corps composés en solution ou en fusion dissociables en deux types d'ions assurant le passage du courant par leur déplacement, les ions positifs se dirigeant vers la cathode et les ions négatifs vers l'anode.

Ainsi, les techniques de fabrication des circuits intégrés CMOS ne permettent de fabriquer que des composants à structure cristalline ordonnée, et sont impuissantes à proposer des solutions de rechange pour l'élaboration de corps à structure amorphe, c'est-à-dire ne possédant pas de réseau cristallin. On connaît toutefois certaines techniques permettant de déposer une couche de matériau amorphe à la surface d'un substrat. Ces techniques ne permettent cependant de déposer que des matériaux ayant une composition chimique simple formée d'un seul composant. Pour des produits plus complexes comme un matériau magnétique qui comprend une pluralité de composants, rien n'a pu être proposé.

La technique retenue par la demanderesse pour réaliser des capteurs magnétiques tels que décrits dans la demande de brevet EP 1 052 519 susmentionnée consiste donc, dans un premier temps, à réaliser sur une plaquette de semi-conducteur un lot de circuits électroniques, puis à scier cette plaquette pour fournir une pluralité de circuits électroniques individuels, et enfin à déposer manuellement sur ces circuits des bandes de matériau magnétique amorphe destinées à former les noyaux ferromagnétiques.

On comprendra aisément qu'une telle technique, si elle peut être utilisée au stade expérimental, n'est nullement applicable à l'échelle industrielle où de très grandes quantités de composants doivent pouvoir être produites rapidement et au moindre coût.

La présente invention a pour but de remédier aux inconvénients mentionnés ci-dessus ainsi qu'à d'autres encore en proposant un procédé de fabrication par lots à la fois fiable et peu coûteux de capteurs magnétiques dont la zone sensible au champ magnétique externe est réalisée en un matériau magnétique amorphe.

A cet effet, la présente invention concerne un procédé pour fabriquer en grand nombre une multiplicité de capteurs magnétiques réalisés sur un substrat semi-conducteur, ces capteurs comprenant au moins un noyau magnétique réalisé en un matériau magnétique amorphe, caractérisé en ce que, après intégration des circuits électroniques associés aux capteurs magnétiques, un film de matériau magnétique amorphe est collé sur le substrat semi-conducteur, ce film étant ensuite structuré pour former les noyaux magnétiques desdits capteurs magnétiques.

Grâce à ces caractéristiques, la présente invention procure un procédé permettant de réaliser toutes les opérations de fabrication de capteurs magnétiques à noyaux magnétiques amorphes sur la plaquette en matériau semi-conducteur dans laquelle sont intégrés les circuits électroniques destinés à être associés auxdits capteurs magnétiques. Il est possible, en particulier, grâce à la présente invention, de fabriquer en lots les noyaux magnétiques réalisés en un matériau magnétique amorphe et de ne scier la plaquette de matériau semi-conducteur qu'une fois les capteurs magnétiques totalement achevés. Un tel procédé permet donc de fabriquer simultanément de grandes quantités de capteurs magnétiques, typiquement de l'ordre de 3000 capteurs ou plus par plaquette de semi-conducteur de seize pouces, de manière extrêmement fiable et avec un faible prix de revient. On s'est notamment rendu compte que l'éventuel désalignement entre noyaux et bobines n'excédait pas les quelques microns, et que les caractéristiques des capteurs magnétiques présentaient une grande uniformité sur une même plaquette, voire sur un lot de plaquettes. Ces résultats particulièrement avantageux sont atteints grâce au fait que, conformément à la présente invention, on vient coller un film de matériau magnétique amorphe tel qu'il est disponible dans le commerce sur la plaquette de matériau semi-conducteur, ce film étant ensuite structuré pour former les noyaux magnétiques avant que la plaquette ne soit finalement sciée pour fournir une pluralité de capteurs individuels prêts à l'emploi. Une telle technique est, bien sûr, bien plus avantageuse que les techniques de l'art antérieur qui consistaient, après avoir intégré les circuits électroniques, à découper la plaquette de matériau semi-conducteur, puis à reporter un à un les noyaux magnétiques sur les circuits.

Selon une autre caractéristique de l'invention, le film de matériau magnétique amorphe est collé sous vide sur le substrat semi-conducteur. On est ainsi assuré que le film sera plaqué contre le substrat semi-conducteur avec une force considérable, ce qui favorise l'adhésion du film sur le substrat et permet d'éviter d'emprisonner des bulles d'air sous la couche métallique.

Selon encore une autre caractéristique de l'invention, le film de matériau magnétique amorphe est structuré à l'aide de techniques de gravure couramment employées dans le domaine de la fabrication des composants semi-conducteurs. On met ainsi en oeuvre des techniques fiables qui permettent de produire les noyaux magnétiques à bas prix de revient et d'assurer une excellente reproductibilité des caractéristiques de ces noyaux.

D'autres caractéristiques et avantages de la présente invention ressortiront plus clairement de la description détaillée qui va suivre d'un exemple de mise en oeuvre du procédé selon l'invention, cet exemple étant donné à titre purement illustratif et non limitatif en liaison avec les dessins annexés dans lesquels :
- la figure 1, déjà citée, est une vue en perspective et en éclaté d'un capteur magnétique comprenant un noyau réalisé en un matériau magnétique amorphe;
- la figure 2 est une vue montrant des bandes de métal amorphe découpées et collées sur un substrat adhésif simple face;
- la figure 3 est une vue d'un masque adhésif servant à procéder à une attaque chimique des bandes de métal représentées sur la figure 1 pour conférer à ces bandes la forme d'une plaquette de semi-conducteur sur laquelle elles seront ultérieurement collées;
- la figure 4 est une vue du masque adhésif de la figure 2 collé sur les bandes de matériau magnétique amorphe;
- la figure 5 est une vue sur laquelle sont représentées les bandes de métal amorphe après l'attaque chimique;
- la figure 6 est une vue de la plaquette de semi-conducteur sur laquelle sont collées les bandes de métal amorphe placée dans un sachet dans lequel on a fait le vide, et
- les figures 7A à 7G sont des schémas de principe illustrant les différentes étapes de mise en oeuvre du procédé conforme à la présente invention.

La présente invention procède de l'idée générale inventive qui consiste à utiliser tel qu'il est disponible dans le commerce un film de matériau magnétique amorphe et à coller ce film sur une plaquette de semi-conducteur dans laquelle ont été préalablement intégrés les circuits électroniques associés aux capteurs magnétiques destinés à être produits. Après cette étape de collage, le film de matériau magnétique amorphe est structuré par gravure pour former les noyaux magnétiques qui constituent la partie sensible au champ magnétique extérieur des capteurs magnétiques. Grâce à ces caractéristiques, on résout le problème posé par les techniques disponibles actuellement pour la fabrication de dispositifs à semi-conducteurs qui ne permettent pas de réaliser des couches amorphes, et on rend possible la fabrication en lots de capteurs magnétiques à noyaux magnétiques amorphes.

La présente invention sera décrite en liaison avec le capteur magnétique enseigné par la demande de brevet EP 1 052 519 au nom de la demanderesse. Il va toutefois de soi que la présente invention n'est nullement limitée à un tel type de capteur et qu'elle s'applique de la même manière à tous types de capteurs magnétiques comprenant un ou plusieurs noyaux magnétiques dont la forme et les dimensions peuvent varier.

On va décrire les différentes étapes d'un procédé permettant de rapporter des noyaux ferromagnétiques réalisés en un matériau magnétique amorphe sur la surface d'une plaquette en matériau semi-conducteur tel que du silicium. La plaquette de silicium, encore appelée "wafer" en anglais, a typiquement un diamètre de six pouces et intègre des circuits de type CMOS standard à sa surface. On s'intéressera tout particulièrement aux étapes qu'il est nécessaire de mettre en oeuvre pour passer d'une plaquette de silicium entière telle qu'elle est livrée par une fonderie, aux circuits intégrés encore appelés "chips" en anglais prêts à être montés sur un circuit imprimé.

Le matériau magnétique amorphe à utiliser est couramment disponible dans le commerce sous la forme de bandes de quelques mètres de long, d'un pouce de largeur et de 18 µm d'épaisseur. La première étape consiste à amincir ces bandes par rodage en ramenant leur épaisseur de 18 à 11 µm, ce qui permet aussi d'améliorer leur état de surface et de diminuer leur rugosité.

Les bandes ainsi obtenues subissent ensuite une légère attaque chimique qui dissout environ un micron de métal sur chacune des faces des bandes, ce qui a pour effet d'annuler les contraintes mécaniques induites à la surface des bandes par l'étape initiale de rodage.

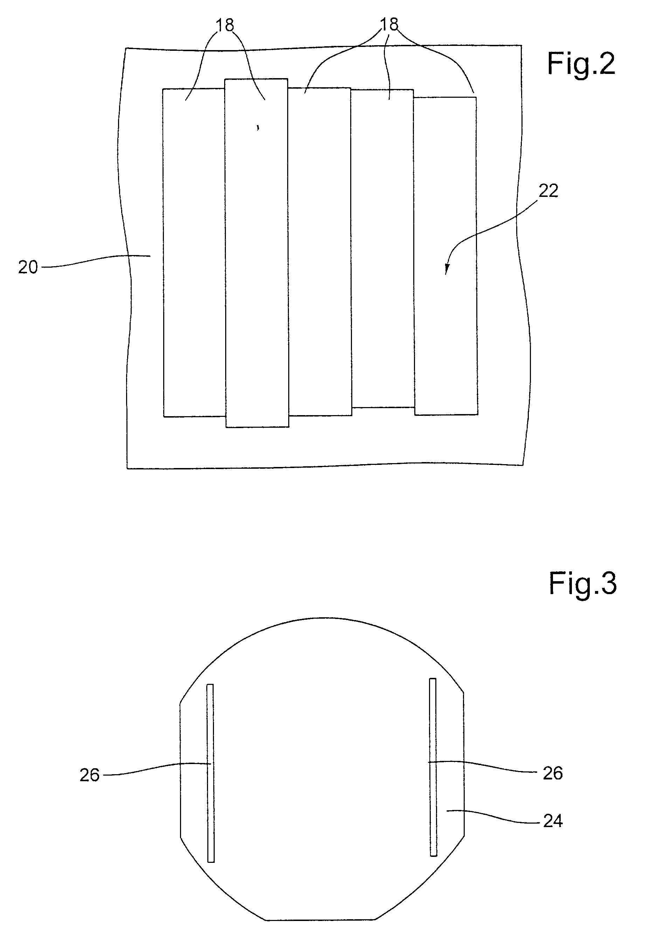

Après cette étape initiale de préparation des bandes, l'une de ces bandes est découpée en plusieurs morceaux 18 qui vont être collés l'un à côté de l'autre sur un support adhésif simple face 20 (voir figure 2), de manière à former une surface qui recouvre au minimum celle du substrat semi-conducteur 4 sur lequel les morceaux 18 de bande en matériau magnétique amorphe sont destinés à être collés.

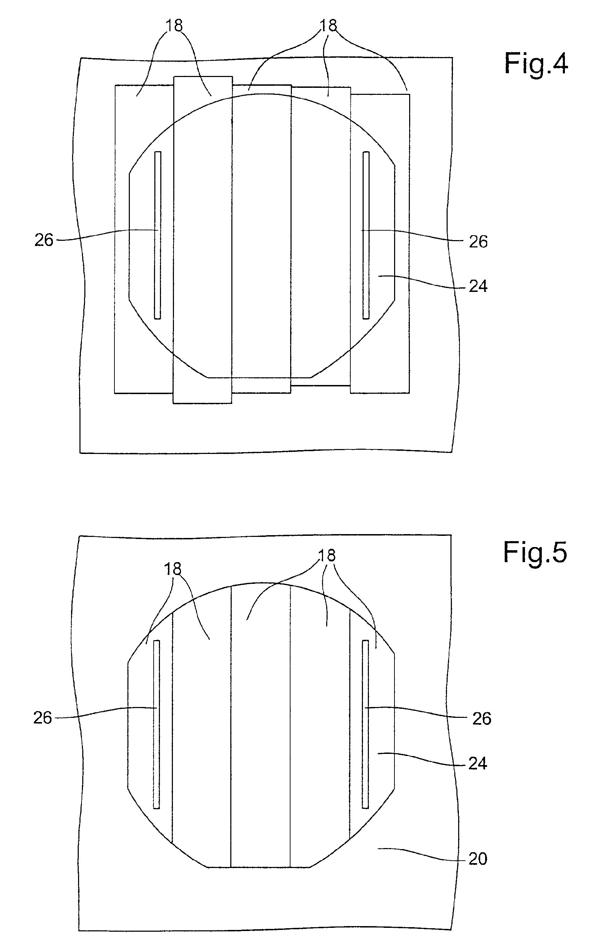

Pour obtenir avec l'ensemble de bandes 18 susmentionné un film de matériau magnétique amorphe 22 dont la forme coïncide avec celle du substrat semi-conducteur 4, un masque adhésif 24 est collé sur le film 22 (voir figure 3) et l'on procède à une attaque chimique à travers ce masque 24. Seules les zones du film de matériau magnétique amorphe 22 non protégées par le masque 24 seront gravées (voir figures 4 et 5). Cette étape permet également de réaliser dans le film 22 des zones de dégagement 26 qui permettront ultérieurement de visualiser, lors de l'étape de photolithographie, des repères d'alignement présents sur le substrat semi-conducteur 4.

Après l'attaque chimique, le substrat adhésif 20 est retiré et les bandes 18 sont nettoyées et séchées sur ce côté non protégé. Le masque adhésif 24 est maintenu en place afin de servir de protection lors de l'étape de collage, en limitant d'éventuelles infiltrations de colle à la surface du film 22. Afin de pouvoir retirer facilement le substrat adhésif 20 sans risquer d'arracher les bandes 18 de matériau magnétique amorphe, il faut que ce substrat 20 ait un pouvoir d'adhésion moindre que celui du masque adhésif 24.

A ce stade de la description, il est important de noter que la réalisation de ce que l'on appelle ici "film" de matériau magnétique amorphe 22 à l'aide de morceaux de bandes 18 juxtaposés du même matériau est uniquement dictée par des impératifs techniques. En effet, il n'existe pas à l'heure actuelle dans le commerce de bandes magnétiques amorphes ayant au moins une largeur égale au diamètre d'un substrat en silicium classique. On est donc obligé d'avoir recours à la technique décrite ci-dessus. Bien entendu, si des bandes plus larges venaient à être disponibles sur le marché, celles-ci seraient préférentiellement utilisées, car elles permettraient d'éviter l'étape qui consiste à coller des morceaux de bandes moins larges sur un support adhésif.

Avant collage des bandes 18 de matériau magnétique amorphe sur la plaquette de semi-conducteur 4, cette dernière est préalablement nettoyée, par exemple au moyen d'acétone puis d'isopropanol, puis rincée à deux reprises avec de l'eau déminéralisée avant d'être séchée en salle blanche. La plaquette 4 peut ensuite être placée dans une étuve afin d'évaporer l'humidité résiduelle, ce qui améliorera le pouvoir d'adhésion de la colle.

La colle 28 utilisée pour coller le film de matériau magnétique amorphe 22 sur la plaquette de semi-conducteur 4 est préparée, puis dégazée. Il peut s'agir d'une colle de type époxy à laquelle un promoteur d'adhésion tel que, par exemple, des microbilles de silice, peut être ajouté si nécessaire.

Une quantité appropriée de colle 28 est placée au centre de la plaquette de semi-conducteur 4 qui est ensuite posée sur un plateau tournant. On fait ensuite tourner la plaquette 4 à vitesse élevée pendant un temps déterminé, par exemple 40 secondes à 4000 tours/minute, de sorte que la colle 28 se répand de manière uniforme par centrifugation sur l'ensemble de la surface de ladite plaquette 4.

Après application de la couche de colle 28, l'ensemble des bandes 18 de matériau magnétique amorphe supportées par le masque adhésif 24 est positionné par rapport à la plaquette de semi-conducteur 4 puis plaqué contre la grande surface supérieure 2 de cette dernière au moyen d'un rouleau presseur ou d'un laminoir, ce qui permet d'éviter d'emprisonner des bulles d'air sous la couche métallique.

Additionnellement, un film de protection supplémentaire, par exemple en Mylar ®, peut être appliqué sur le masque adhésif 24, dans le but d'éviter les remontées de colle.

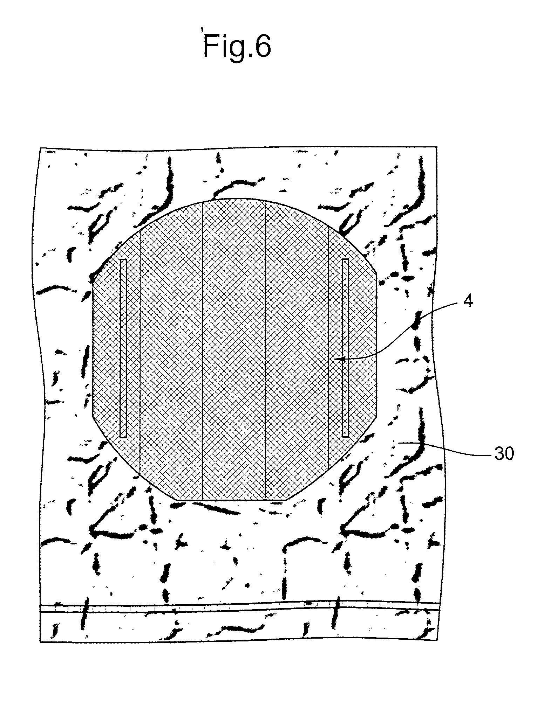

La plaquette de semi-conducteur 4 sur laquelle ont été appliquées les bandes 18 de matériau magnétique amorphe maintenues ensemble par le masque adhésif 24 éventuellement recouvert par le film de protection susmentionné est placée dans un sachet de mise sous vide 30 (voir figure 6). Après avoir fait le vide dans le sachet 30, celui-ci est hermétiquement scellé, puis ramené à la pression atmosphérique ambiante. La pression atmosphérique exerce alors une force qui plaque le film 22 de matériau magnétique amorphe contre la plaquette de semi-conducteur 4. Une plaque de maintien peut encore être posée au dessus du film de protection avant ensachage pour éviter le décollement des bandes 18 lors de la mise sous vide.

La polymérisation de la colle susmentionnée s'effectue dans une étuve à 60 °C pendant au moins 48 heures.

Le collage terminé, la plaquette de semi-conducteur 4 est retirée du sachet de mise sous vide 30. Le masque adhésif 24 est enlevé, puis la plaquette 4 est nettoyée et étuvée.

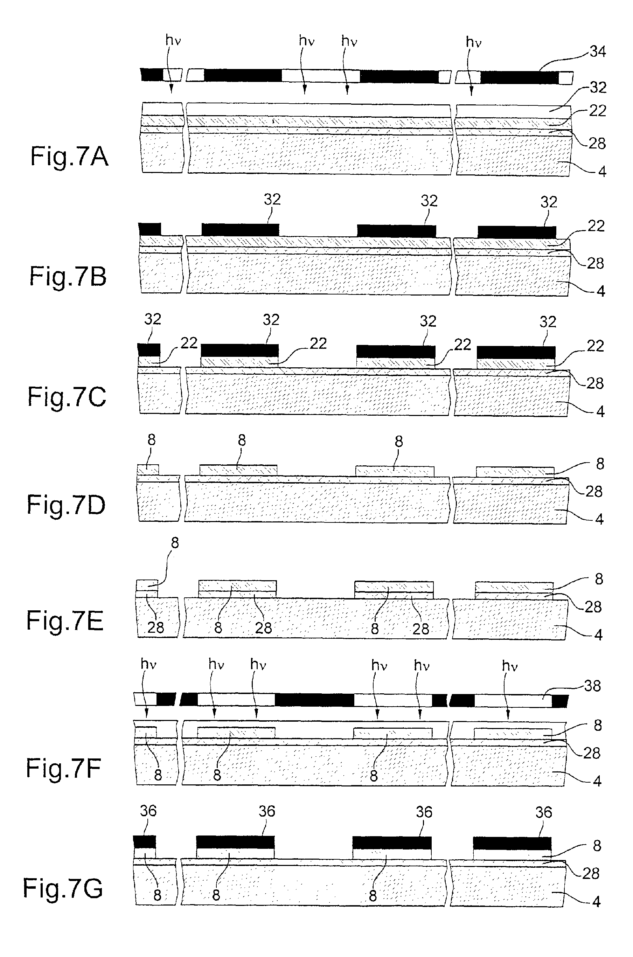

On s'intéresse maintenant, en liaison avec les figures 7A à 7G, aux étapes de photolithographie qui permettent de structurer le film 22 de métal amorphe pour former les noyaux magnétiques des capteurs magnétiques.

On commence tout d'abord par déposer une couche 32 de résine photosensible positive sur toute la surface du film de métal amorphe 22 (figure 7A). La sensibilisation de la couche de résine photosensible 32 est ensuite opérée au moyen d'une lumière ultraviolette passant par les zones transparentes d'un masque de photogravure 34 convenablement aligné par rapport à la plaquette de semi-conducteur 4 et reproduisant les zones à sensibiliser. La couche de résine photosensible 32 est ensuite développée et n'occupe plus finalement que les endroits où devront se trouver les noyaux magnétiques 8 sur la plaquette 4 (figure 7B). Un contrôle au microscope permet de s'assurer que le développement de la résine photosensible 32 s'est effectué convenablement.

L'étape suivante du procédé selon l'invention consiste à graver le film métallique 22. A cet effet, une solution de gravure chimique est pulvérisée sur toute la surface de la plaquette de semi-conducteur 4 afin d'attaquer le métal amorphe partout où il n'est pas protégé par la couche de résine photosensible positive 32 (figure 7C). Durant cette étape, la plaquette de semi-conducteur 4 se déplace sur un tapis roulant dans une chambre où des jets pulvérisent la solution d'attaque chimique sur les deux faces de ladite plaquette 4, ce qui permet à cette solution d'attaque d'être sans cesse renouvelée et d'assurer une attaque rapide et uniforme.

L'attaque dure de 1min30 à 2min. Elle est stoppée en rinçant la plaquette de semi-conducteur 4 avec de l'eau déionisée. La couche de résine photosensible 32 qui reste est ensuite éliminée (figure 7D). Les noyaux ferromagnétiques 8 ainsi obtenus peuvent être observés au microscope électronique afin de vérifier leurs dimensions ainsi que leur état de surface.

On s'intéresse maintenant à l'étape d'élimination de la couche de colle 28 résiduelle qui va être décrite en liaison avec la figure 7E.

En effet, la couche de colle 28 qui recouvre toute la plaquette de semi-conducteur 4 a résisté à l'attaque chimique susdécrite. Il faut donc éliminer cette couche de colle 28 afin de mettre à nu les zones de connexion électriques des capteurs 1. A cette fin, on soumet la plaquette 4 à une attaque par plasma dans lequel le réactif d'attaque est de l'oxygène. La durée du traitement est d'au moins 240 minutes. Les tests effectués à la suite de l'attaque par plasma montrent que l'état de surface des plages de connexion est tel que les techniques habituelles de liaison de ces plages de connexion aux circuits imprimés sur lesquels les capteurs magnétiques 1 sont destinés à être fixés peuvent être utilisées.

Finalement, une couche épaisse 36 de résine photosensible négative est déposée au-dessus des noyaux magnétiques 8 afin que ceux-ci ne puissent être détériorés, voire décollés au cours des opérations suivantes (figure 7F). La couche 36 de résine photosensible ne doit cependant pas recouvrir les zones de connexion du capteur magnétique 1 afin que ces dernières puissent ultérieurement être connectées au circuit imprimé sur lequel ledit capteur 1 va être monté.

On comprendra que la couche de colle résiduelle 28 doit être éliminée avant dépôt de la couche 36 de résine négative faute de quoi cette couche de résine 36 adhérera mal sur le substrat.

La résine photosensible négative 36 est répandue sur la plaquette de semi-conducteur 4 par centrifugation, puis exposée à la lumière à travers un second masque de photogravure 38 et enfin développée (figure 7G). De cette manière, une couche de résine négative 36 de l'ordre de quelques dizaines de microns d'épaisseur peut être déposée au-dessus de chaque noyau 8, afin de protéger efficacement ces noyaux 8.

Finalement, la plaquette de semi-conducteur est sciée pour fournir une pluralité de capteurs magnétiques 1 individuels qui sont ensuite stockés dans des boîtes antistatiques.

La protection conférée par la couche de résine 36 s'avère particulièrement utile lors du sciage de la plaquette de semi-conducteur 4, de la manipulation des capteurs magnétiques individuels et en particulier lors de leur assemblage sur le circuit final.

Il va de soi que la présente invention n'est pas limitée au mode de réalisation qui vient d'être décrit et que diverses modifications et variantes simples peuvent être envisagées sans sortir du cadre de la présente invention.

## Revendications

1. Procédé pour fabriquer en grand nombre une multiplicité de capteurs magnétiques (1) réalisés sur un substrat semi-conducteur (4), ces capteurs (1) comprenant au moins un noyau magnétique (8) réalisé en un matériau magnétique amorphe, **caractérisé en ce que**, après intégration des circuits électroniques associés aux capteurs magnétiques (1), un film (22) de matériau magnétique amorphe est collé sur le substrat semi-conducteur (4), ce film (22) étant ensuite structuré pour former les noyaux magnétiques (8) desdits capteurs magnétiques (1).

2. Procédé selon la revendication 1, **caractérisé en ce que**, avant collage, le film (22) de matériau magnétique amorphe est amené aux dimensions du substrat semi-conducteur (4) sur lequel il est destiné à être collé.

3. Procédé selon la revendication 2, **caractérisé en ce que**, pour conférer au film (22) de matériau magnétique amorphe une dimension correspondant à celle du substrat semi-conducteur (4), on effectue une attaque chimique à travers un masque (24) convenablement conformé, de sorte que seules les régions du film (22) qui ne sont pas protégées par le masque (24) seront gravées.

4. Procédé selon l'une quelconque des revendications 1 à 3, **caractérisé en ce que** le film (22) de matériau magnétique amorphe est collé sous vide sur le substrat semi-conducteur (4).

5. Procédé selon la revendication 4, **caractérisé en ce que** le film (22) de matériau magnétique amorphe est positionné par rapport au substrat semi-conducteur (4), puis déposé sur la surface (2) de ce dernier, le tout étant ensuite placé dans un sachet (30) dans lequel on fait le vide et qui est ensuite hermétiquement scellé avant d'être ramené à la pression atmosphérique ambiante, la pression atmosphérique exerçant alors une force qui plaque le film (22) de matériau magnétique amorphe contre le substrat semi-conducteur (4).

6. Procédé selon la revendication 5, **caractérisé en ce que**, avant ensachage, un film de protection est disposé au-dessus du film (22) de matériau magnétique amorphe afin d'éviter d'éventuelles remontées de colle (28).

7. Procédé selon l'une quelconque des revendications 1 à 6, **caractérisé en ce que**, après collage, une couche de résine photosensible positive (32) est déposée sur le film (22) de matériau magnétique amorphe, puis insolée à travers un masque de photogravure (34), la résine photosensible (32) étant ensuite développée et n'occupant finalement plus que les endroits du substrat semi-conducteur (4) où devront se trouver les noyaux magnétiques (8).

8. Procédé selon la revendication 7, **caractérisé en ce qu'**une solution de gravure chimique est pulvérisée sur toute la surface du substrat semi-conducteur (4) afin d'éliminer le matériau magnétique amorphe (22) partout où il n'est pas protégé par la couche de résine photosensible (32).

9. Procédé selon la revendication 8, **caractérisé en ce que**, après gravure, une couche de résine photosensible négative (36) est déposée sur le substrat semi-conducteur (4) puis insolée à travers un masque de photogravure (38), la résine photosensible (36) étant ensuite développée et ne subsistant qu'au-dessus des noyaux magnétiques (8) qu'elle protège.

10. Procédé selon la revendication 9, **caractérisé en ce que** la colle (28) qui recouvre encore toute la surface (2) du substrat semi-conducteur (4) est éliminée par attaque plasma.

11. Procédé selon l'une quelconque des revendications 1 à 10, **caractérisé en ce que** le substrat semi-conducteur (4) est scié pour fournir une pluralité de capteurs magnétiques (1) individuels.

12. Procédé selon l'une quelconque des revendications 1 à 11, **caractérisé en ce que**, après préparation, la colle (28) utilisée pour coller le film (22) de matériau magnétique amorphe sur le substrat semi-conducteur (4) est dégazée puis épandue sur ledit substrat semi-conducteur (4) par centrifugation.

13. Procédé selon la revendication 12, **caractérisé en ce que** la colle (28) est une colle de type époxy à laquelle un promoteur d'adhésion peut être ajouté.

14. Procédé selon l'une quelconque des revendications 1à 13, **caractérisé en ce que**, avant collage du film (22) de matériau magnétique amorphe, le substrat semi-conducteur (4) est d'abord nettoyé, puis placé dans une étuve pour évaporer l'humidité résiduelle, ce qui améliore l'adhésion.

15. Procédé selon l'une quelconque des revendications 1 à 14, **caractérisé en ce que** le film (22) de matériau magnétique amorphe est obtenu à partir d'une bande découpée en plusieurs sections (18) qui sont disposées les unes à côté des autres, de manière à former une surface qui corresponde au minimum à celle du substrat semi-conducteur (4).

16. Procédé selon la revendication 15, **caractérisé en ce que** la bande de matériau semi-conducteur est amincie par rodage, puis subit une attaque chimique pour dissoudre une faible quantité de métal sur chaque côté de la bande afin d'éliminer les contraintes mécaniques induites en surface par le rodage.

17. Procédé selon l'une quelconque des revendications 15 ou 16, **caractérisé en ce que** les sections (18) de bande de matériau magnétique amorphe sont collées sur un support adhésif simple face (20).

18. Procédé selon la revendication 17, **caractérisé en ce que** le masque (24) utilisé pour effectuer l'attaque chimique qui va amener le film (22) de matériau magnétique amorphe aux dimensions du substrat semi-conducteur (4) est collé sur la face libre dudit film (22).

19. Procédé selon la revendication 18, **caractérisé en ce que** le support adhésif (20) est retiré après l'attaque chimique, les bandes (18) étant nettoyées et séchées sur ce côté qui n'est pas protégé et l'adhésif (24) ayant servi de masque restant en place afin de servir ultérieurement de protection lors du collage du film (22) de matériau magnétique amorphe sur le substrat semi-conducteur (4).
